(19) Europäisches Patentamt
European Patent Office
Office européen des brevets

(11) EP 0 911 976 A1

(12) EUROPEAN PATENT APPLICATION

(43) Date of publication:
28.04.1999 Bulletin 1999/17

(51) Int Cl.⁶: H03M 1/18

(21) Application number: 98402386.1

(22) Date of filing: 28.09.1998

(84) Designated Contracting States:
AT BE CH CY DE DK ES FI FR GB GR IE IT LI LU
MC NL PT SE
Designated Extension States:
AL LT LV MK RO SI

(30) Priority: 09.10.1997 FR 9712601

(71) Applicant: THOMSON multimedia
92100 Boulogne Billancourt (FR)

(72) Inventors:
• Bonhoure, Bruno
92100 Boulogne Billancourt (FR)
• Paillardet, Frédéric
92100 Boulogne Billancourt (FR)

(74) Representative: Ruellan-Lemonnier, Brigitte et al
THOMSON multimedia,
46 quai A. Le Gallo
92648 Boulogne Cédex (FR)

(54) **Analog/digital conversion device with sample-and-hold circuit**

(57)    Device for the analog/digital conversion of an input signal (Vin) comprising a sample-and-hold unit (1) for providing stable voltage porches from said input signal; said device further comprising a gain stage (9) connected to the output of said sample-and-hold unit (9), a loop (9, 10, 11) for restoring a DC component (VDC) of the signal at the output of said gain stage, said loop comprising an amplifier (9) mounted in negative feedback for providing a gain of said gain stage, an analog-digital converter (3) connected to the output of said gain stage.

The invention is used in particular in cable receivers.

FIG.1

## Description

The invention relates to an analog/digital conversion device, with sample-and-hold unit particularly adapted to the reception of signals transmitted by cable.

The basis of the invention has consisted in developing a conversion device suitable for the analog-digital conversion of a QPSK modulated signal within the frequency spectrum from 20 to 25 MHz and with a peak-to-peak dynamic swing of 1 volt, the input signal being applied via a capacitive coupling.

The capacitive coupling results in the loss of the continuous component of the input signal, which in the case of a QPSK signal is due to the distortions experienced during transmission, the power transmitted by a QPSK signal being zero. Moreover, the dynamic swing of the signal is only 1 volt peak-to-peak, this being relatively little for conversion on for example 8 bits. This problem will also have to be taken into account as will that related to the frequency band of the input signal, which is not compatible with cheap converters. Lastly, an attempt will be made to minimize certain forms of noise.

The subject of the invention is a device for the analog/digital conversion of an input signal comprising

- a sample-and-hold unit for providing stable voltage porches from said input signal; said device further comprising:
- a gain stage connected to the output of said sample-and-hold unit;
- a loop for restoring a DC component of the signal at the output of said gain stage, said loop comprising an amplifier mounted in negative feedback for providing a gain of said gain stage;
- an analog-digital converter connected to the output of said gain stage.

According to a particular embodiment of the invention, said DC component converges to the mid-voltage of the conversion range of the converter.

According to a particular embodiment, said amplifier comprises a positive input for receiving said voltage porches from said sample-and-hold circuit and a negative input for receiving a DC component restoration voltage.

According to a particular embodiment, said loop for restoring said DC component comprises a switched current source for charging or discharging a capacitor for storing said DC component restoration voltage according to a value of a most significant bit at the output of said converter.

Other characteristics of the invention will emerge via the description of a particular non-limiting illustrative embodiment depicted by the two appended figures, in which:

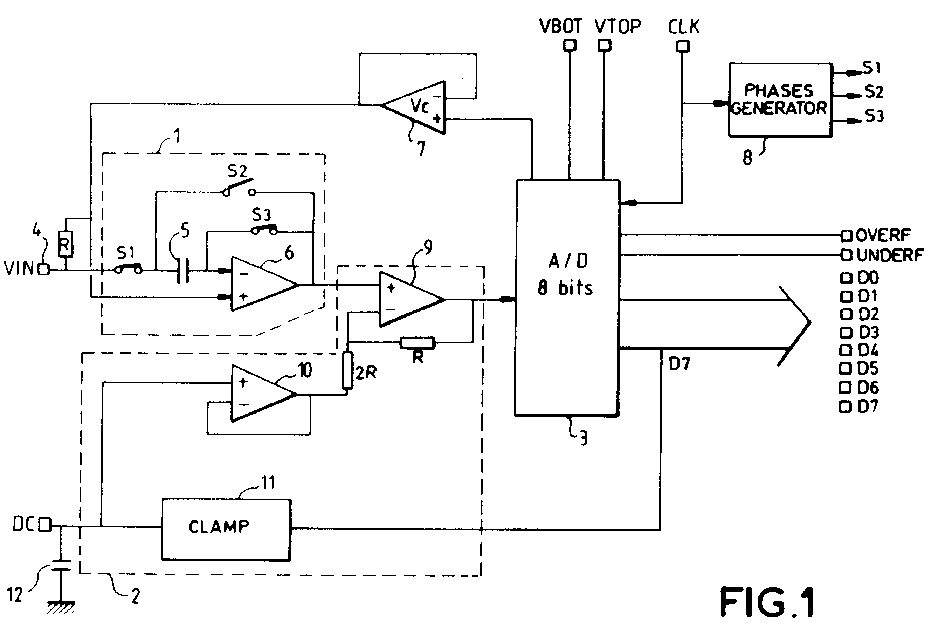

Figure 1 is a functional electrical diagram of the conversion circuit in accordance with the present illustrative embodiment;

Figure 2 is a timing diagram of control signals for the interrupters of a sample-and-hold unit employed within the present example.

The circuit comprises three parts: a sample-and-hold unit 1, a gain stage 2 for restoring the continuous component and a converter 3 proper.

The function of the sample-and-hold unit is to feed a stable voltage porch to the converter 3 during the acquisition phase of the latter, for the purpose of obtaining a conversion of quality. This mode of operation makes it possible to render the signal to be quantized "pseudo-static". This allows the use of an analog/digital converter whose frequency constraints at input are less strict than the passband of the input signal would normally allow.

The sample-and-hold unit comprises an input 4 to which is applied the input signal VIN via a capacitive coupling (not depicted). The terminal 4 is linked via a first interrupter S1 and a capacitor 5 to the negative input of an operational amplifier 6. A second interrupter, called S2, links the output of the amplifier 6 to that terminal of the capacitor 5 which is connected to the interrupter S1. A third interrupter S3, likewise connected to the output of the amplifier 6, links this output to the negative input of the same amplifier. Finally, the positive input of the amplifier 6 receives a bias voltage, which in this case is the voltage Vc, the mid-voltage of the conversion range of the converter 3.

The amplifier 6 is preferably an operational amplifier with a high "slew rate" (the maximum rate of variation of output voltage).

This bias voltage is buffered by an operational amplifier 7 with unit gain, which receives at its positive input the voltage Vc originating from the converter 3. The output of the amplifier 7 is connected via a resistor (not depicted) to the input terminal Vin, so as to bias this input node, the signal Vin being applied via a coupling capacitor, the circuit being supplied with voltages of 0 volts (earth) and 3.3 volts (supply voltage proper). In the calculations which follow, Vin + Vc will therefore be regarded as the input voltage, rather than simply Vin.

According to a variant embodiment, a low-pass filter filters the voltage Vc originating from the converter.

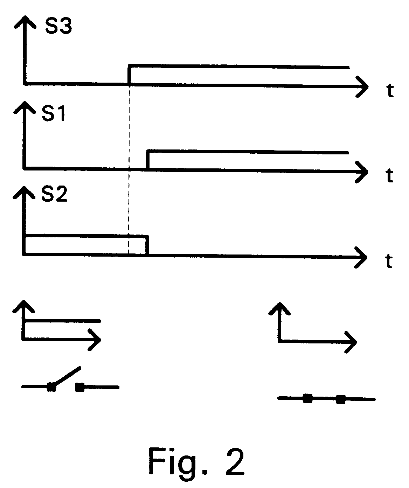

The manner of operation of the sample-and-hold unit is as follows, Figure 2 depicting the timing diagrams for the controls for the various interrupters:

Initially, S3 is on (closed), thereby carrying out an auto-zero function. At this juncture, S1 is also closed, but S2 is open. This phase is called the "tracking mode", the capacitor 5 being charged to the potential to be sampled.

Subsequently, S3 is open. S1 is opened thereafter, after a short lag intended to allow the charges accumulated in S3 to drain away.

S2 is then closed, thus transferring the charge from the capacitor 5 to the output of the amplifier 6, which is also the output of the sample-and-hold unit: the sampled voltage is then available for subsequent processing.

The control signals for S1, S2 and S3 are generated from the clock CLK of the converter and are synchronous with this clock via a generator 8.

Stage 2 has two functions, namely, on the one hand, increasing the dynamic swing of the signal to be converted so as to increase the quantization level and thereby improve the signal/noise ratio, and on the other hand, to restore the continuous component of the sampled input signal.

Stage 2 comprises an amplifier 9 whose positive input is linked to the output of the sample-and-hold unit, and whose output loops back to the negative input by way of a resistor R. The negative input of the amplifier 9 is moreover connected via a resistor 2R to a voltage source formed by an amplifier 10 with unit gain. The positive input of this amplifier 10 is connected to a clamping voltage VDC generated by a circuit 11 and stored in an external storage capacitor 12.

The transfer function of stage 2 is as follows:

$$Vout = 1.5(Vc + Vin)\text{-}0.5VDC \qquad (1)$$

The clamp loop comprises a switched current source 11, yielding a current of intensity Io or -Io depending on the value of the most significant bit (D7) at the output of the converter 3. The capacitor 12 is thus charged or discharged depending on the phase of its control signal.

The clamp loop causes the clamp voltage VDC to converge to Vc, the mid-voltage of the reference chain of the converter. The biasing of the amplifier 9 is performed with the aid of this voltage VDC.

In the absence of input signal, and by putting Vout = Vc to obtain an optimum continuous component at the input of the converter 3, equation 1 becomes:

$$Vc = 1.5Vc - 0.5VDC$$

or alternatively

$$VDC = Vc.$$

The ratio of the resistances of the gain stage is chosen judiciously so as to simultaneously allow this convergence of the d.c. voltage at the output of the gain stage and to introduce the desired gain in the input voltage.

The converter 3 is an 8-bit converter with semi-flash structure. In the present illustrative embodiment, it is a converter with comparators with auto-zero which works in three phases, namely a phase of acquisition of the voltage to be converted for the determination of the most significant bits, a phase of determining the most significant bits and a phase of determining the least significant bits. The converter comprises a chain of resistors generating the set of reference voltages for the comparators.

The converter comprises, at output, the bus D0 to D7, as well as two overflow signals OVERF and UNDERF.

The converter 3 receives the voltages VBOT and VTOP delimiting the conversion range. Voltage Vc delivered to the buffer amplifier 7 is tapped off from the middle of the chain of resistors. According to a variant embodiment, it is filtered with the aid of a low-pass before being delivered to the buffer amplifier 7.

## Claims

1. Device for the analog/digital conversion of an input signal (Vin) comprising

   - a sample-and-hold unit (1) for providing stable voltage porches from said input signal; said device being characterized in that it further comprises:
   - a gain stage (9) connected to the output of said sample-and-hold unit (9);
   - a loop (9, 10, 11) for restoring a DC component (VDC) of the signal at the output of said gain stage, said loop comprising an amplifier (9) mounted in negative feedback for providing a gain of said gain stage;
   - an analog-digital converter (3) connected to the output of said gain stage.

2. Device according to claim 1, characterized in that said DC component converges to the mid-voltage (Vc) of the conversion range of the converter (3).

3. Device according to claim 1, characterized in that said amplifier (9) comprises a positive input for receiving said voltage porches from said sample-and-hold circuit (1) and a negative input for receiving a DC component restoration voltage.

4. Device according to claim 3, wherein said loop for restoring said DC component comprises a switched current source (11) for charging or discharging a capacitor (12) for storing said DC component restoration voltage (12) according to a value of a most significant bit (D7) at the output of said converter (3).

**FIG.1**

VBOT  VTOP  CLK

PHASES
GENERATOR

S1
S2
S3

8

A/D
8 bits

OVERF
UNDERF
D0
D1
D2
D3
D4
D5
D6
D7

D7

3

Vc

7

1

S2

S3

S1

5

6

9

10

2R

R

VIN

R

4

CLAMP

11

DC

12

2

EP 0 911 976 A1

Fig. 2

**European Patent Office**

**EUROPEAN SEARCH REPORT**

Application Number

EP 98 40 2386

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP 0 539 259 A (ELA MEDICAL SA) 28 April 1993 | 1-3 | H03M1/18 |
| Y | * figures 1,6 * | 4 | |
| | --- | | |
| Y | US 5 084 700 A (CHRISTOPHER TODD J) 28 January 1992 * figures 1,3 * | 4 | |
| | --- | | |
| A | PATENT ABSTRACTS OF JAPAN vol. 015, no. 295 (E-1094), 26 July 1991 & JP 03 104418 A (MATSUSHITA ELECTRIC IND CO LTD), 1 May 1991 * abstract * | 1 | |
| | ----- | | |

| | | | TECHNICAL FIELDS SEARCHED (Int.Cl.6) |
|---|---|---|---|
| | | | H03M |

The present search report has been drawn up for all claims

| Place of search | Date of completion of the search | Examiner |
|---|---|---|
| THE HAGUE | 26 February 1999 | Verhoof, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 0 911 976 A1**

### ANNEX TO THE EUROPEAN SEARCH REPORT
### ON EUROPEAN PATENT APPLICATION NO.

EP 98 40 2386

26-02-1999

| Patent document cited in search report | | Publication date | Patent family member(s) | | Publication date |
|---|---|---|---|---|---|
| EP 0539259 | A | 28-04-1993 | FR | 2682866 A | 30-04-1993 |
| | | | DE | 69215331 D | 02-01-1997 |
| | | | DE | 69215331 T | 03-04-1997 |
| US 5084700 | A | 28-01-1992 | CN | 1063986 A | 26-08-1992 |
| | | | EP | 0498262 A | 12-08-1992 |
| | | | JP | 5083594 A | 02-04-1993 |
| | | | MX | 9200474 A | 01-08-1992 |

EPO FORM P0459